Europäisches Patentamt

European Patent Office

Office européen des brevets

(19)

(11) EP 0 755 118 A1

(12) EUROPEAN PATENT APPLICATION

(43) Date of publication:
22.01.1997 Bulletin 1997/04

(51) Int Cl.6: H03K 17/945

(21) Application number: 96305291.5

(22) Date of filing: 18.07.1996

(84) Designated Contracting States:
DE FR GB IT

(30) Priority: 19.07.1995 GB 9514756

(71) Applicant: BIRT ELECTRONIC SYSTEMS
LIMITED
Buckinghamshire MK16 0JN (GB)

(72) Inventor: Birt, L.A.
Woolstones, Milton Keynes, MK9 0BQ (GB)

(74) Representative: Gibson, Stewart Harry
URQUHART-DYKES & LORD,
Three Trinity Court,
21-27 Newport Road
Cardiff CF2 1AA (GB)

(54) Sensing circuit

(57) A sensing circuit comprises a sensor (10), e.g. a Hall effect sensing device, means (20) for generating pulses of relatively short duration at zero voltage crossing points of the A.C. mains supply, and means (12) for supplying power to the sensor (10) only for the duration of those pulses. The sensor (10) is operative to control the switching of power from the A.C. mains supply to a load (28) depending on the level of a parameter (magnetic flux in the case of a Hall effect sensing device) to which the sensor (10) is subjected.

Figure 1

# Description

This invention relates to a sensing circuit and more particularly to a sensing circuit for switching A.C. devices on and off.

It is well known to provide a sensing circuit for controlling the switching of A.C. power to an A.C. device or load in accordance with the level of a sensed parameter. Such a sensing circuit requires a low D.C. power supply which it necessarily receives direct from the high voltage A.C. supply through a resistor/rectifier arrangement. Every 4 mA supply current requirement of the sensing circuit produces one watt of power, which is dissipated as heat via the resistor/rectifier arrangement mentioned above. In order to maximise the efficiency of such sensing circuits, therefore, it is necessary to minimise their supply current requirement and thereby minimise the heat generation.

A well-established arrangement for switching A.C. devices or loads comprises a triac which is connected between the sensing circuit and the load. In response to the output of the sensing circuit, zero crossing trigger pulses are applied to the gate (control input) of the triac each time the A.C. supply voltage drops to zero during each half-cycle. Each trigger pulse has a duration of approximately 100 microseconds and no further control to the triac is required for the remainder of each half-cycle.

Semiconductor Hall effect devices are well known for use in sensing circuits: such devices detect a magnetic field and produce an electrical output signal related to the magnitude of the magnetic field. As a cost-saving, the low voltage electronic sensing circuitry is often supplied direct from the high voltage A.C. mains supply, the excess power being simply dissipated as heat in a resistive element. However, typically for every 4 mA consumed by the circuitry from a 240 volts A.C. supply, 1 watt of electrical power is dissipated as heat. Thus, Hall effect sensors are inefficient and unsuitable for many purposes.

We have now devised a sensing circuit which overcomes the problems outlined above and which is driven directly from the A.C. mains supply but which consumes relatively little current and dissipates relatively little power as heat.

In accordance with the present invention there is provided a sensing circuit driven by an A.C. mains supply, said circuit comprising a sensor device, means for generating pulses of relatively short duration at zero voltage crossing points of said A.C. mains supply, and means for supplying power to said sensor device only for the duration of said pulses, said sensor device being operative to control the switching of power from said A.C. mains supply to a load depending on the level of a parameter to which the sensor device is subjected.

Thus, since the sensor device is only consuming current for the relatively short duration of the zero voltage crossing pulses, substantially reduced current consumption and, therefore, heat dissipation is achieved.

Preferably the zero voltage crossing pulses are applied to the base of a transistor which is connected in series with the sensor device, such that the transistor and, therefore, the sensor device, are switched on for the duration of the pulses.

Preferably the circuit further comprises means for providing the required D.C. power supply to the sensing circuit directly from the A.C. mains supply. Preferably the output of the sensor device is applied to the inverting input of a comparator, the non-inverting input of which is held at a reference voltage, preferably half of the D.C. supply voltage. Preferably the output of the comparator, which is preferably high when the parameter sensed by the sensor device exceeds a predetermined level, is applied to a triac which controls the switching of A.C. power to the load, preferably such that when the sensed parameter exceeds the predetermined level, the triac switches the A.C. power to the load.

In particular, the sensor device may comprise a Hall effect device, for sensing magnetic flux. The device may however comprise an opto sensor.

An embodiment of the present invention will now be described by way of example only and with reference to the accompanying drawings, in which:

FIGURE 1 is a block diagram of a sensing circuit in accordance with the present invention;

FIGURE 2 is a circuit diagram of a controller including a sensing circuit in accordance with the present invention:

FIGURE 3 is a diagram showing that an opto-sensor may replace the Hall effect device of Figures 1 and 2; and

FIGURE 4 shows use of the circuit of Figure 2 in a switch.

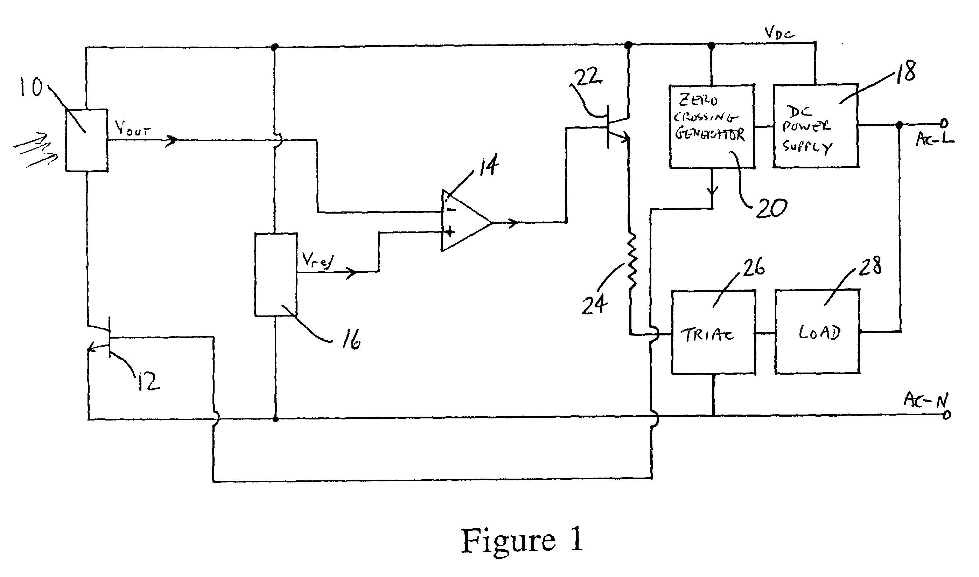

Referring to Figure 1 of the drawings, a sensing circuit according to the present invention comprises a semiconductor Hall effect device 10 which is connected in series with the collector of a transistor 12. The Hall effect device 10 and the transistor 12 are connected across D.C. supply rails, and the output of the Hall effect device 10 is connected to the inverting input of a comparator 14. The non-inverting input of the comparator 14 is connected to a potentiometer network 16 which provides a reference voltage $V_{ref}$. A power supply 18 provides a D.C. power supply $V_{DC}$ from the A.C. supply rail, and a zero crossing generator 20 generates output pulses in response to every zero crossing of the A.C. supply. The output pulses from the zero crossing generator 20 are applied to the base of the transistor 12. The output of the comparator 14 is connected to the base of a second transistor 22 the collector circuit of which comprises a resistor 24 connected to a triac 26 which is in series with a load 28 across the A.C. supply.

Initially, the inverting input of comparator 14 is held at $V_{DC}$, such that the output of the comparator is held low and no power is supplied to the load 28. In use, the zero crossing generator 20 generates a pulse at each zero crossing of the A.C. supply, each pulse having a duration of approximately 100 microseconds and being applied to the base of transistor 12, thereby switching it on and consequently supplying current to the Hall effect device 10: thus, the Hall effect device 10 is only powered for approximately 100 microseconds in each half-cycle of the A.C. supply (i.e. for approximately 100 microseconds in every 10 ms for a 50Hz A.C. supply). During that period, the comparator 14 compares the output of the Hall effect device 10 at the inverting input with $V_{ref}$ at the non-inverting input, where $V_{ref}$ is preferably around $V_{DC}/2$. The output voltage $V_{out}$ of the Hall effect device 10 is indicative of the magnetic flux which the device is subjected to: $V_{out}$ decreases with increasing magnetic flux. If $V_{out}$ remains higher than $V_{ref}$, then the output of the comparator 14 remains low, such that the triac 26 remains off and no A.C. power is supplied to the load 28. However, if the magnetic flux increases to such a level that it causes $V_{out}$ to fall below $V_{ref}$, then the output of comparator 14 goes high while the Hall effect device is powered, i.e. for the duration of the zero crossing pulse, and triggers the triac 26 on. The triac 26 in turn switches A.C. power to the load 28 for the duration of the next half cycle of the A.C. supply. Thus, the Hall effect circuit of the present invention enables A.C. power to be switched to a load 28 when magnetic flux is above a predetermined threshold level. In other words, when the magnetic flux strength is above a predetermined level, the Hall effect circuit of the present invention provides a continuous train of zero crossing triggering pulses to the triac 26 which switches A.C. power to the load 28, and when the magnetic flux strength is below that predetermined level, the circuit switches off the power to the load 28.

Typical Hall effect semiconductor integrated circuits require around 15mA of supply current, such that such devices produce over 3.5 watts of excess power, which must be dissipated as heat via a resistor arrangement. However, since the Hall effect device in the circuit arrangement according to the present invention is only switched on for around 100 microseconds in every 10 ms, the supply current required is only:

$$15 \text{ mA} \times 0.1/10 = 0.15 \text{ mA}$$

Thus, the heat required to be dissipated is substantially reduced and the arrangement provides an efficient method of switching A.C. power to the load.

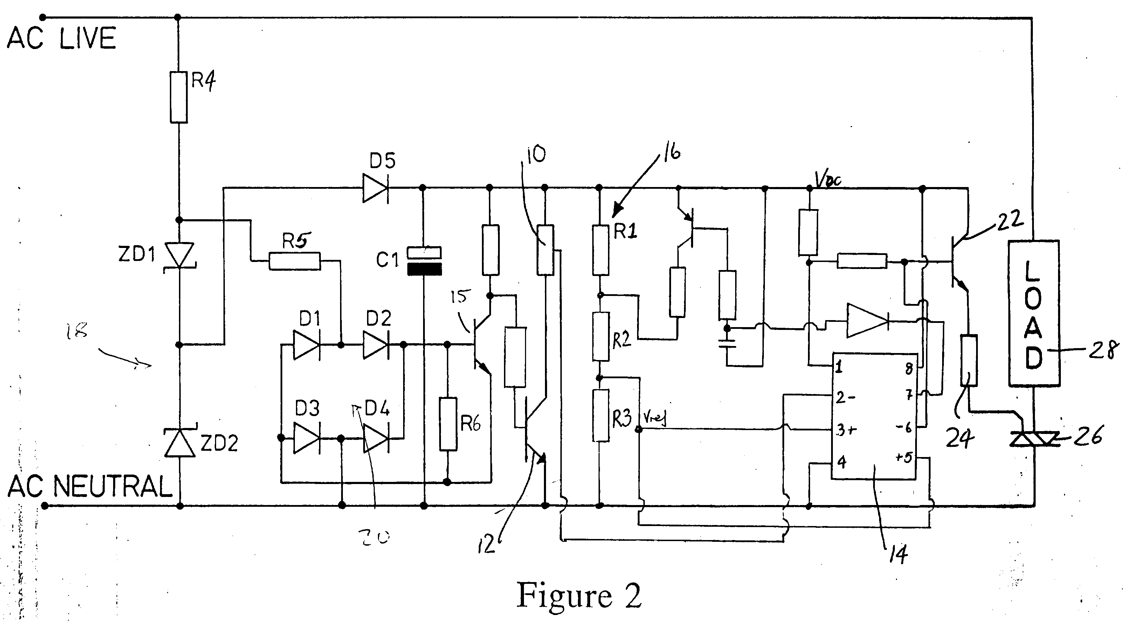

Figure 2 shows the Hall effect device 10 and transistor 12 connected across the D.C. supply, and the potentiometer 16 comprising resistors R1, R2 and R3 connected in series across the D.C. supply: the reference voltage V ref is taken from the junction between resistors R2 and R3 and an integrated circuit provides the comparator 14, which controls the triac 26 via the transistor 22. The D.C power supply 18 is formed by a series circuit of resistor R4 and two oppositely-poled zener diodes ZD1 and ZD2 connected across the 240 volts A.C. mains supply, and a rectifying diode D5 connecting the junction between the two zener diodes ZD1 and ZD2 to the D.C. supply rail V. A smoothing capacitor C1 is connected between the D.C. supply rail V and the mains neutral. The zero-crossing generator 20 comprises a full-wave rectifier bridge formed by diodes D1 to D4 has one node connected to mains neutral, and its opposite node connected to the junction between resistor R4 and zener ZD1 through a resistor R5. A resistor R6 is connected across the other diagonal of the rectifier bridge and across the base-emitter junction of a transistor 15, the collector of which is connected by a resistor to the +ve rail $V_{DC}$. The collector of transistor 15 delivers narrow pulses at the zero crossing of the A.C. supply waveform, as explained in our patent No. 2 261 084. Transistor 15 is held in saturation (therefore holding transistor 12 non-conductive) except for the duration of each such narrow pulse.

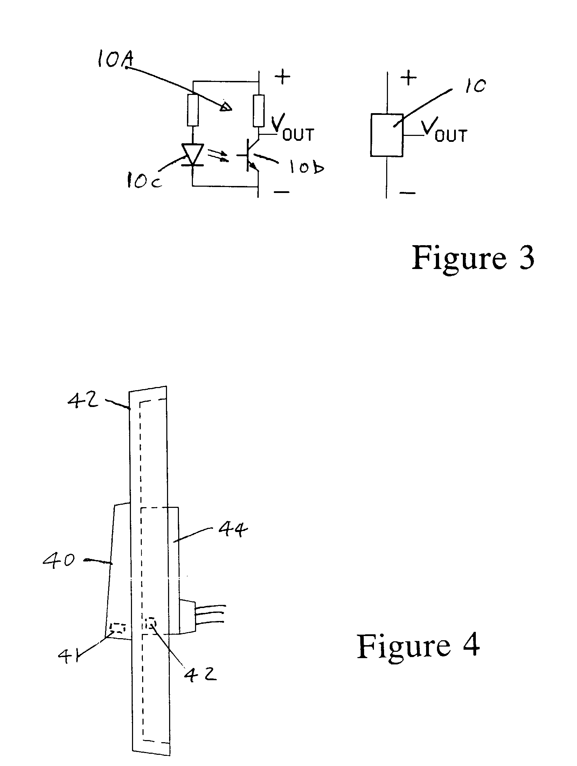

As shown in Figure 3, the Hall effect device 10 may be replaced by an opto-sensor 10A, similarly connected in series with the transistor 12 across the D.C. supply and providing an output $V_{OUT}$ according to the light received by the photosensitive component 10b of the device from its light emitting diode component 10c.

Figure 4 shows use of the Hall effect sensing circuit of Figures 1 and 2 in a switch, e.g. a light switch. A manual switch 40, preferably of rocker type, is mounted to the front surface of a faceplate 42 and carries a small permanent magnet 41. A sealed unit 44 is mounted to the rear of the faceplate 42 and contains the circuit of Figure 2 (except the load), the Hall effect device being indicated at 10. Electrical conductors lead from the unit 44 to the load and to the A.C. supply. The switch itself is accordingly waterproof and, because it does not include mechanical contacts, is arc-free.

## Claims

1. A sensing circuit driven by an A.C. mains supply, said circuit comprising a sensor device, means for generating pulses of relatively short duration at zero voltage crossing points of said A.C. mains supply, and means for supplying power to said sensor device only for the duration of said pulses, said sensor device being operative to control the switching of power from said A.C. mains supply to a load depending on the level of a parameter to which said sensor device is subjected.

2. A sensing circuit as claimed in Claim 1, wherein said zero voltage crossing pulses are applied to the base of a transistor which is connected in series with said sensor device, such that said transistor and said sensor device are switched on for the duration of said pulses.

3. A sensing circuit as claimed in Claim 1 or 2, comprising means for providing a D.C. power supply to said sensor device directly from said A.C. mains supply.

4. A sensing circuit as claimed in any preceding claim, wherein the output of said sensor device is applied to the inverting input of a comparator, the non-inverting input of which is held at a reference voltage.

5. A sensing circuit as claimed in Claim 4, wherein said reference voltage is equal to half the voltage of said D.C. power supply.

6. A sensing circuit as claimed in Claim 4 or 5, wherein the output of said comparator is applied to a triac which controls the switching of power from said A.C. mains supply to said load.

7. A sensing circuit as claimed in Claim 6, arranged so that the output of said comparator is high when said parameter exceeds said predetermined level.

8. A sensing circuit as claimed in Claim 6 or 7, arranged so that when said parameter sensed by sensor device exceeds said predetermined level, said triac switches power from said A.C. mains supply to said load.

9. A sensing circuit as claimed in any preceding claim, in which sensor device comprises a Hall effect device.

10. A sensing circuit as claimed in any one of claims 1 to 8, in which said sensor device comprises an opto-sensor.

$V_{DC}$

10

ZERO
CROSSING
GENERATOR

DC
POWER
SUPPLY

18

$V_{OUT}$

22

20

14

AC-L

$V_{ref}$

16

24

26

28

12

TRIAC

LOAD

AC-N

Figure 1

EP 0 755 118 A1

Figure 2

10A

10c

V_OUT

10b

+

−

10

V_OUT

+

−

## Figure 3

42

44

40

41

42

## Figure 4

## EUROPEAN SEARCH REPORT

European Patent Office

**Application Number**

EP 96 30 5291

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 620 647 (NAMCO CONTROLS CORP) 19 October 1994<br>* page 2, line 34 - line 52 *<br>* page 4, line 25 - line 35 *<br>* page 5, line 3 - line 8 *<br>* page 7, line 6 - line 21 *<br>* figures 2-4 * | 1-4,6-9 | H03K17/945 |
| A | PATENT ABSTRACTS OF JAPAN<br>vol. 012, no. 140 (P-696), 28 April 1988<br>& JP-A-62 262253 (MITSUBISHI ELECTRIC CORP), 14 November 1987,<br>* abstract * | 1 | |
| A | PATENT ABSTRACTS OF JAPAN<br>vol. 018, no. 353 (P-1764), 4 July 1994<br>& JP-A-06 089504 (TEAC CORP), 29 March 1994,<br>* abstract * | 10 | |

**TECHNICAL FIELDS SEARCHED** (Int.Cl.6)

H03K

The present search report has been drawn up for all claims

| Place of search | Date of completion of the search | Examiner |
|---|---|---|
| THE HAGUE | 28 October 1996 | D/L PINTA BALLE.., L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)